# EUROPÄISCHE PATENTSCHRIFT

(11) **EP 1 843 402 B1**
(45) Veröffentlichungstag und Bekanntmachung des Hinweises auf die Patenterteilung: **30.11.2011**
(21) Anmeldenummer: 07005997.7
(22) Anmeldetag: 23.03.2007
(51) Int. Cl.: F21K 99/00, H01L 25/075

(54) **Halbleiter-Leuchtmittel und dessen Verwendung in einem Leuchtpaneel**
Semiconductor lighting means and illumination panel comprising the same
Système lumineux semi-conducteur et panneau lumineux doté d'un tel système

(30) Priorität: 04.04.2006 DE 102006015606
(43) Veröffentlichungstag der Anmeldung: 10.10.2007
(73) Patentinhaber: Noctron Soparfi S.A., 8140 Bridel (LU)
(72) Erfinder: Diamantidis, Georg, 56307 Dernbach (DE)
(74) Vertreter: Ostertag, Reinhard

(56) Entgegenhaltungen:
- EP-A- 1 475 846
- WO-A-2004/021461
- US-A1- 2005 139 854

## Beschreibung

Die Erfindung betrifft ein Halbleiter-Leuchtmittel gemäß dem Oberbegriff des Anspruches 1 sowie ein Leuchtpaneel mit solchen.

Halbleiter-Leuchtmittel sind in Form von Leuchtdioden-Leuchtmitteln bekannt, bei welchen die pn-Übergänge enthaltenden Halbleiter-Kristalle von lichtundurchlässigen Unterlagen getragen sind.

Halbleiter-Leuchtkristalle strahlen aus der Rekombination von Elektronen und Löchern stammendes Licht aber in allen Richtungen ab. Bei den bekannten Halbleiter-Leuchtmitteln geht somit das in den hinteren Halbraum ausgestrahlte Licht zum großen Teil oder ganz verloren.

Bei einem aus der EP 1 475 846 A2 bekannten Halbleiter-Leuchtmittel der eingangs genannten Art ist das das leuchtende Halbleiter-Leuchtelement tragende Substrat für das vom Halbleiter-Leuchtelement erzeugte Licht durchlässig. Dort geht nach hinten abgestrahltes Licht nicht verloren und kann verwendet werden, wobei gegebenenfalls hinter dem Leuchtmittel angeordnete Spiegel dafür sorgen können, dass das Licht, welches nach hinten emittiert wird, ebenfalls in den vorderen Halbraum gelangt.

Bei dem aus der EP 1 475 846 A2 bekannten Halbleiter-Leuchtmittel sind mehrere Halbleiter-Leuchtelemente überlappend angeordnet, wodurch es zu Abschattungen kommt, durch welche die Leuchtdichte des Halbleiter-Leuchtmittels verringert ist, wenn die Halbleiter-Leuchtelemente nur teilweise für Licht durchlässig oder lichtundurchlässig sind.

Durch die vorliegende Erfindung soll ein Halbleiter-Leuchtmittel gemäß dem Oberbegriff des Anspruchs 1 so weitergebildet werden, dass die Menge des Nutzlichtes vergrößert ist.

Diese Aufgabe ist erfindungsgemäß gelöst durch ein Halbleiter-Leuchtmittel mit den im Anspruch 1 angegebenen Merkmalen.

Auf diese Weise wird für den Fall, dass die Halbleiter-Leuchtelemente nur teilweise für Licht durchlässig sind oder lichtundurchlässig sind, eine hohe Leuchtdichte erhalten, wobei für beide Sätze von Halbleiter-Leuchtelementen das in Vorwärts- bzw. in Rückwärtsrichtung abgegebene Licht genutzt wird. Dass die Halbleiter-Leuchtelemente der beiden Sätze auf verschiedenen Seiten des Substrates angeordnet sind, hat auch Vorteile im Hinblick auf eine gute Wärmeabfuhr von den Halbleiter-Leuchtelementen.

Vorteilhafte Weiterbildungen der Erfindung sind in Unteransprüchen angegeben.

Die im Anspruch 2 angegebenen Materialien für das das Halbleiter-Leuchtelement tragende Substrat sind nicht nur lichtdurchlässig sondern im Volumen klar, so dass das Substrat zu keiner Lichtstreuung führt.

Das im Anspruch 3 angegebene Substrat zeichnet sich durch besonders gute Härte und gute Lichtdurchlässigkeit in einem großen Wellenlängenbereich aus. Dieses Substrat ist auch chemisch besonders beständig und daher auch als Unterlage bei lithographischen Verfahren gut verwendbar.

Die im Anspruch 4 angegebenen Dickenverhältnisse für das Substrat sind im Hinblick auf geringes Gewicht und geringe Kosten des Substrates von Vorteil.

Verwendet man in dem Halbleiter-Leuchtelement als Lichtquellen Dreischicht-Strukturen, wie sie im Anspruch 5 angegeben ist, so wird die dem Leuchtelement zugeführte elektrische Energie mit besonders hohem Wirkungsgrad in Licht umgesetzt und das Spektrum lässt sich beeinflussen.

Bei einem Leuchtmittel gemäß Anspruch 6 kann auch das im Inneren des Halbleiterelementes entstehend Licht Nutzzwecken zugeführt werden. Auch kann Licht durch hinter den Halbleiter-Leuchtelementen stehende Spiegel in den vorderen Halbraum reflektiert werden.

Die Weiterbildung der Erfindung gemäß Anspruch 7 erlaubt es, auch räumlich ausgedehnte Leuchtmittel zu realisieren, insbesondere auch flächige Leuchtmittel.

Bei einem Leuchtelement gemäß Anspruch 8 ist das Substrat zusammen mit den von ihm getragenen Halbleiter-Leuchtelementen gegen mechanische Einwirkungen von außen weitgehend geschützt.

Dabei ist die Weiterbildung der Erfindung gemäß Anspruch 9 wieder im Hinblick auf die Realisierung flächiger Leuchtmittel von Vorteil.

Die Weiterbildung der Erfindung gemäß Anspruch 10 ist im Hinblick auf gute Kühlung der Halbleiter-Leuchtelemente von Vorteil.

Als lichtdurchlässige Kühlflüssigkeit hat sich dabei gemäß Anspruch 11 insbesondere Silikonöl bewährt. Dieses zeichnet sich auch durch große chemische Beständigkeit auch bei hohen Temperaturen aus.

Ein Leuchtmittel, wie es im Anspruch 12 angegeben ist, erzeugt weißes Licht, obwohl die Halbleiter-Leuchtelemente im UV oder im Blauen emittieren.

Die Ansprüche 13 und 14 geben bevorzugte Alternativen dafür an, die das Weißlicht erzeugenden Phosphorpartikel gleichförmig zu verteilen.

Für manche Anwendungsfälle ist es vorteilhaft, ein Standard-Leuchtmittel zu haben, welches Licht gleichermaßen nach vorne und hinten abstrahlt. Gemäß Anspruch 15 kann man ein derartiges Leuchtmittel so modifizieren, dass das insgesamt von dem Halbleiter-Leuchtelement ausgesandte Licht für vom Standardfall abweichende Anwendungen nach vorne abgestrahlt wird.

Die Weiterbildung der Erfindung gemäß Anspruch 16 ist im Hinblick auf guten Wirkungsgrad des Reflektorteiles von Vorteil.

Die Weiterbildungen der Erfindung gemäß den Ansprüchen 17 bis 19 gestattet es, dass Leuchtmittel mit einer hohen Betriebsspannung im Bereich von einigen 100 V bis zu einigen kV zu betreiben. Diese ist für manche Anwendungsfälle, wo das Vorliegen einer Hochspannung geprüft werden soll, von Vorteil. Bei einem Leuchtmittel gemäß einem der Ansprüche 17 bis 19 braucht man für derartige Einsatzzwecke keinen Spannungsteiler.

Dabei ist die Weiterbildung der Erfindung gemäß Anspruch 20 wieder im Hinblick auf ein Erzeugen von weißlicht mit hohem Wirkungsgrad von Vorteil.

Ein Leuchtmittel, wie es im Anspruch 21 angegeben ist, kann direkt mit einer Hochspannungsquelle betrieben werden.

Die Weiterbildungen der Ansprüche 22 bis 25 sind im Hinblick auf ein einfaches Anbringen von Phosphorpartikeln an gewünschten Stellen von Vorteil.

Anspruch 26 gibt ein Leuchtpaneel an, welches auch in sehr großen Abmessungen gefertigt werden kann, da die einzelnen Leuchtmittel gute mechanische Stabilität haben. Es zeigt auch eine gute Wärmeabfuhr von den Leuchtmitteln und damit auch von den in diesen enthaltenen Halbleiter-Leuchtelementen.

Bei einem Leuchtpaneel gemäß Anspruch 27 wird das gesamte erzeugte Licht in den gleichen Halbraum abgegeben.

Die Weiterbildung der Erfindung gemäß Anspruch 28 ist im Hinblick auf die Gleichförmigkeit der Helligkeit des Leuchtpaneeles von Vorteil.

Nachstehend wird die Erfindung anhand von Ausführungsbeispielen unter Bezugnahme auf die Zeichnung näher erläutert. In dieser zeigen:
- Figur 1: eine schematische Aufsicht auf eine Leucht- element-Einheit, welche allein oder zusammen mit gleichen Einheiten in einem Gehäuse angeordnet ein Leuchtmittel bilden kann;
- Figur 2: eine Ansicht eines Halbleiter-Leuchtmittels, welches eine Vielzahl von Leuchtmittel-Einhei- ten nach Figur 1 umfasst;
- Figur 3: eine Aufsicht auf ein weiteres Halbleiter-Leuchtmittel;
- Figur 4: einen Schnitt durch ein ausgedehntes, flächiges Halbleiter-Leuchtpaneel;
- Figur 5: eine vergrößerte Aufsicht auf eine Leuchtmittel-komponente;
- Figur 6: eine Aufsicht auf ein Leuchtmittel, welches man durch Aufbonden der Leuchtmittelkomponente von Figur 5 auf ein Basissubstrat erhält;
- Figur 7: eine schematische seitliche Darstellung eines von der Außengeometrie her diodenähnlichen Leuchtmittels;
- Figur 8: eine Aufsicht auf ein abgewandeltes Leucht-mittel, welches sechs Licht emittierende Halbleiter-Leuchtelemente aufweist; und
- Figur 9: eine ähnliche Ansicht wie Figur 8, wobei jedoch das Leuchtmittel so abgewandelt ist, daß es weißes Licht abstrahlt und wahlweise auch mit einer Hochspannung betrieben werden kann.
- Figur 10: einen Schnitt durch ein weiteres Ausführungs-beispiel eines Leuchtelementes entlang der Schnittlinie x-x in Figur 11;
- Figur 11: einen Schnitt durch das Leuchtelement nach Figur 10 entlang der dortigen Schnittlinie XI-XI in anderem Maßstab;
- Figur 12: einen der Figur 11 entsprechenden Schnitt durch ein Weiteres Ausführungsbeispiel eines Leuchtelements;
- Figur 13: einen der Figur 11 entsprechenden Schnitt durch ein weiteres Ausführungsbeispiel eines Leuchtelements;
- Figur 14: einen der Figur 11 entsprechenden Schnitt durch ein weiteres Ausführungsbeispiel eines Leuchtelements; und
- Figur 15: einen der Figur 11 entsprechenden Schnitt durch ein weiteres Ausführungsbeispiel eines Leuchtelements.

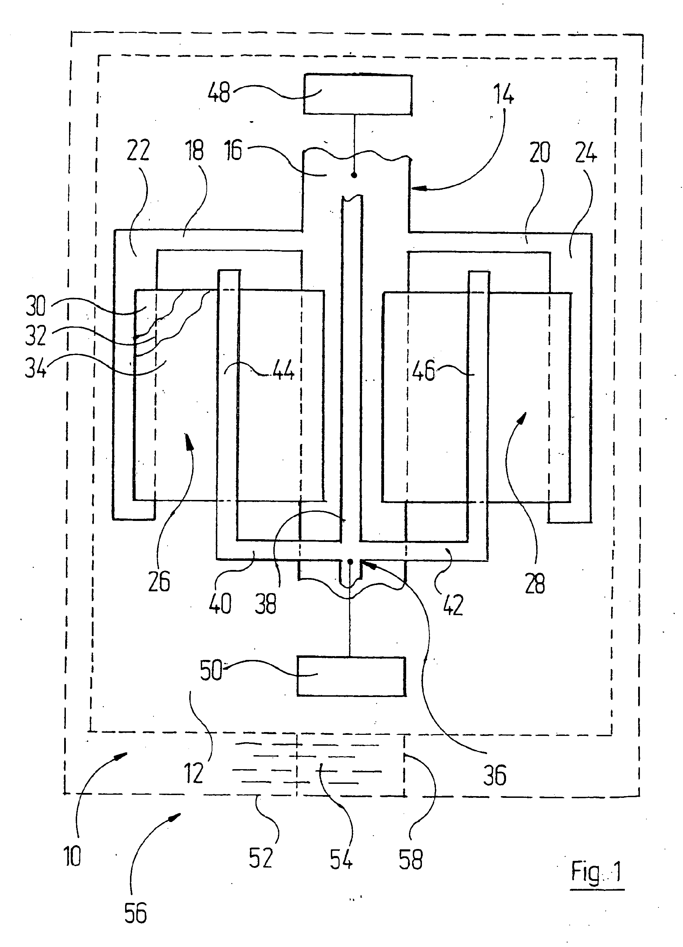

In Figur 1 ist mit 10 insgesamt eine Leuchtelement-Einheit bezeichnet, welche ein aus Korundglas (Al₂O₃-Glas) hergestelltes transparentes Substrat 12 umfasst. Derartige Gläser werden auch unter der Bezeichnung Saphirglas vertrieben. Sie zeichnen sich durch eine hohe mechanische Festigkeit, gute elektrische Isolationseigenschaften und gute thermische Eigenschaften aus. Das Substrat 12 hat in der Praxis eine Dicke von 300 bis 400 µm.

Auf der Oberseite des Substrates 12 ist eine insgesamt mit 14 bezeichnete erste Elektrode angeordnet.

Diese umfasst eine mittlere Anschlußleiterbahn 16, die über transversale Arme 18, 20 parallel zur Anschlußleiterbahn 16 verlaufende Kontaktarme 22, 24 trägt.

Zwei flächige Leuchtelemente 26, 28 sind so über die Anschlußleiterbahn 16 und die Kontaktarme 22, 24 gelegt, daß sie letztere teilweise in transversaler Richtung überlappen, wie aus der Zeichnung ersichtlich.

Jedes der Leuchtelemente 26, 28 umfasst drei Schichten: Eine untere Schicht 30, welche die Anschlußleiterbahn 16 und die Kontaktarme 22, 24 kontaktiert und aus einem p-leitenden III-V-Halbleiter-Material gefertigt ist, z. B. InGaN.

Eine mittlere Schicht 32 ist eine MQW-Schicht. MQW ist die Abkürzung für multiple quantum well. Ein MQW Material stellt ein Übergitter dar, welches eine gemäß der Übergitterstruktur veränderte elektronische Bandstruktur aufweist und entsprechend bei anderen Wellenlängen Licht emittiert. Über die Parameter der MQW-Schicht läßt sich das Spektrum des von den Leuchtelementen 26, 28 abgegebenen Lichtes beeinflussen.

Eine obere Schicht 34 ist eine n-leitende oder eigenleitende Schicht, die z. B. aus GaN bestehen kann.

Die drei Schichten haben insgesamt so geringe Dicke, daß die gesamte Dreischicht-Struktur für Licht durchlässig ist.

Auf die vorhergehend beschriebene Struktur ist eine zweite Elektrode 36 aufgedampft.

Diese hat eine Anschlußleiterbahn 38, die über eine dünne Oxidschicht auf die oben beschriebene Struktur gelegt ist und über transversale Arme 40, 42 Kontaktarme 44, 46 trägt, die in der Mitte über die oberen Schichten 34 der Leuchtelemente 26, 28 verlaufen.

Die Elektroden 14, 36 sind mit einer oberen Anschlußplatte 48 bzw. einer unteren Anschlußplatte 50 verbunden, die unter Betriebsbedingungen mit den Klemmen einer Spannungsquelle verbunden sind.

Auf diese Weise geben die Leuchtelemente 26, 28 bei Spannungsbeaufschlagung in Rückwärtsrichtung Licht ab, welches bei den o. g. Halbleitermaterialien im Bereich von 280 bis 360 nm und 360 bis 465 nm liegt.

Dieses Licht kann die Leuchtelement-Einheit 10 nach beiden Seiten hin verlassen, da das Substrat 12 und auch die Elektroden 14 und 36 transparent sind.

In der Praxis wird eine Leuchtelement-Einheit 10, wie sie oben beschrieben wurde, in ein transparentes Gehäuse 52 eingebaut, welches in Figur 1 nur gestrichelt dargestellt ist.

In den Zwischenraum zwischen dem Gehäuse 52 und die Leuchtelement-Einheit 10 ist Silikonöl 54 eingefüllt. Diese Flüssigkeit dient zur Wärmeabfuhr von der Leuchtelement-Einheit 10. Sie ist chemisch so inert, daß sie in direkten Kontakt zu den Materialien der Leuchtelement-Einheit 10 treten kann, ohne daß diese hierunter leiden. Silikonöl läßt sich auch sehr gut und bleibend entgasen und ist in den hier interessierenden Wellenlängenbereichen der elektromagnetischen Strahlung durchsichtig.

Zur mechanischen Anbindung des Substrates 12 an das Gehäuse 52 dient ein Glassockel 58.

Die Leuchtelement-Einheit 10 bildet zusammen mit dem Außengehäuse 52 und dem in dieses eingeschlossene Volumen an Silikonöl ein insgesamt mit 56 bezeichnetes Leuchtmittel.

Das Flüssigkeitsvolumen ist in der Zeichnung nur beispielhaft in einem Teilbereich des Geäuseinneren gezeigt. In Wirklichkeit füllt es das Gehäuseinnere vollständig aus. Dies gilt auch für die weiteren Figuren.

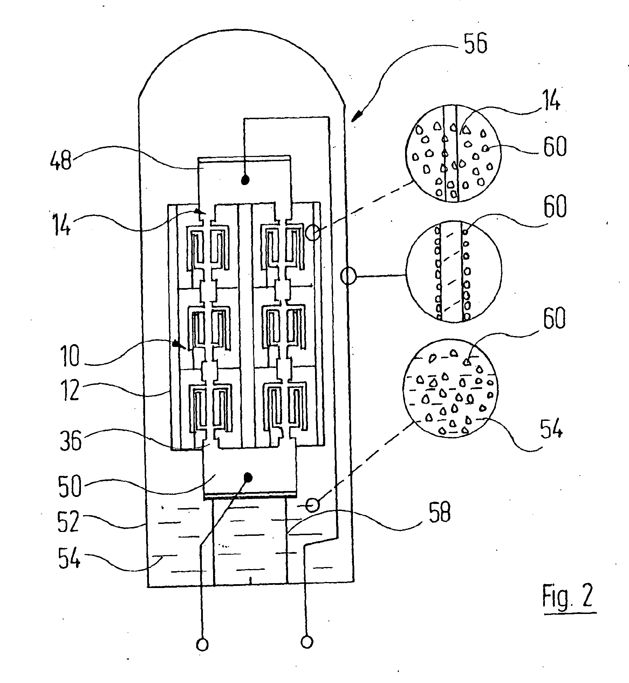

Zur Erhöhung der Lichtmenge des Leuchtmittels kann man eine Mehrzahl von Leuchtelement-Einheiten 10, wie sie obenstehend unter Bezugnahme auf Figur 1 erläutert wurden, auf einem gemeinsamen Substrat zusammenfassen.
Ein entsprechendes Leuchtmittel 56 ist in Figur 2 dargestellt. Komponenten, die obenstehend unter Bezugnahme auf Figur 1 schon in funktionsäquivalenter Form erläutert wurden, sind wieder mit denselben Bezugszeichen versehen. Diese brauchen nachstehend nicht nochmals detailliert beschrieben zu werden.

Man erkennt, daß auf dem Substrat 12 sechs Leuchtelement-Einheiten angeordnet sind, von denen jeweils drei elektrisch in Reihe geschaltet sind. Die beiden Sätze aus drei in Reihe geschalteten Leuchtelement-Einheiten 10 sind in Parallelschaltung zwischen die Anschlußplatten 48, 50 geschaltet.

Wie oben dargelegt, strahlen die Leuchtelement-Einheiten 10 bei den genannten Halbleiter-Materialien im ultravioletten und im Blauen aus.

Um unter Verwendung dieser Leuchtelement-Einheiten eine Weißlichtquelle zu realisieren, sind in dem Silikonöl 54 Phosphorpartikel 60 verteilt, die aus einem Farbzentren aufweisenden transparenten Festkörpermaterial hergestellt sind.

Es finden drei Arten von Phosphorpartikeln Verwendung, die jeweils das von den Leuchtelement-Einheiten 10 ausgesandte UV-Licht und blaue Licht absorbieren und im Blauen, Gelben und Roten emittieren. Die Mengenverhältnisse zwischen den drei Phosphorpartikeln sind so gewählt, dass man unter Berücksichtung eines ggfs. unterschiedlichen Wirkungsgrades der Lichtwellen-Umsetzung für die verschiedenen Phosphorpartikel insgesamt vom Leuchtmittel 56 ein weißes Licht erhält.

Alternativ oder zusätzlich kann man vorsehen, dass die Innenfläche und/oder des Außengehäuses 52 mit Phosphorpartikeln 60 beschichtet ist. Dies kann z. B. dadurch erfolgen, dass man die entsprechende Seite des Außengehäuses 52 mit einem transparenten Lack überzieht und auf diesen in noch klebrigen Zustand die Phosphorpartikel-Mischung bläst. Dies ist in Figur 2 ebenfalls in einer Ausschnittsvergrößerung dargestellt.

Nochmals alternativ oder zusätzlich kann man eine derartige Partikelbeschichtung auch für die Leuchtelement-Einheit 10 vorsehen, wie ebenfalls in Figur 2 in einer Ausschnittsvergrößerung dargestellt.

In den Figuren 1 und 2 sind Beispiele gezeigt, welche das Verständnis der Erfindung erleichtern sollen.

Wie oben dargelegt, ist die gesamte Leuchtelement-Einheit 10 transparent (sowohl das Substrat 12 als auch die Elektroden 14, 36 als auch die Leuchtelemente 26, 28). Aus diesem Grunde ist vorzugsweise auf die Rückseite des Substrates 12 nochmals genau die gleiche Anordnung von Elektroden und Leuchtelemente aufgebracht. Man erhält so bei gleichem Volumen des Leuchtmittels 56 die doppelte Lichtmenge.

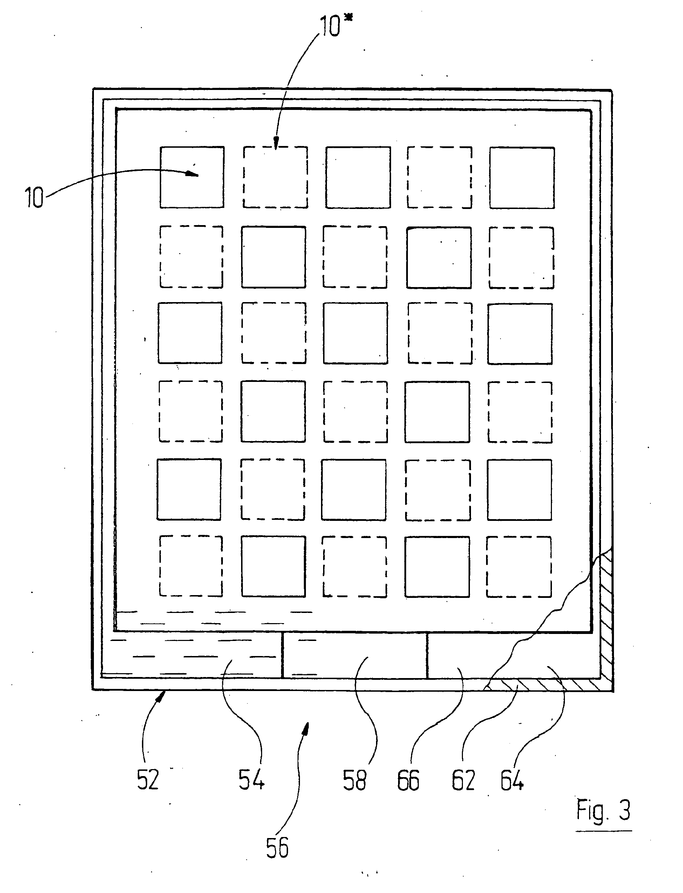

Figur 3 zeigt ein nochmals ausgedehnteres flächiges Leuchtmittel 56, wie es zur Hinterleuchtung von Displays verwendet werden kann. Man erkennt die in einer Matrix angeordneten Leuchtelement-Einheiten 10, wobei nun die auf den beiden Seiten des Substrates 12 angeordneten Leuchtelement-Einheiten gegeneinander versetzt sind. Eine derartige Anordnung wird gewählt, wenn die Leuchtelement-Einheiten 10 selbst nicht lichtdurchlässig sind.

Das Außengehäuse 52 besteht nun aus einem äußeren Rahmen 62 und Deckplatten 64, 66. Diese haben eine nach Art von Mattglas aufgerauhte Innenfläche, um den Lichtstrom zu vergleichmäßigen.

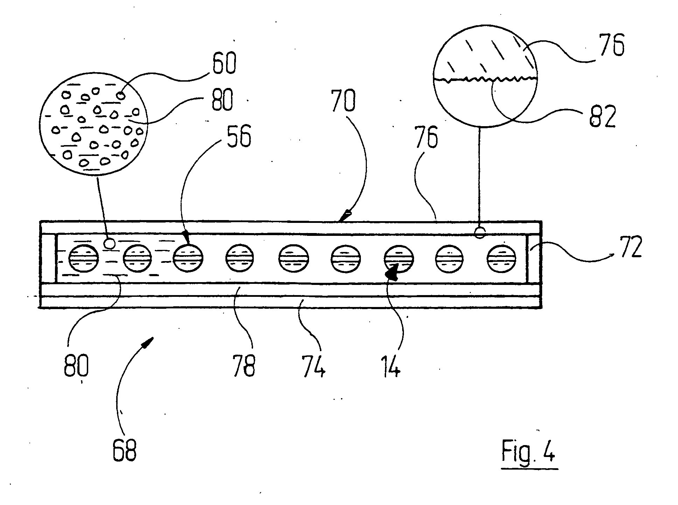

Das Ausführungsbeispiel nach Figur 4 zeigt ein Halbleiter-Leuchtpaneel 68. Im Inneren eines ähnlich wie in Figur 3 ausgebildeten Paneelgehäuses 70 einzelne zylindrische Leuchtmittel 56 angeordnet, wie sie in Figur 2 gezeigt sind, wobei jedoch die Anzahl der in Serie geschalteten Leuchtelement-Einheiten 10 eines Leuchtmittels größer sein kann, z. B. 10 oder 20 Einheiten.

Das Paneelgehäuse 70 hat einen Rahmen 72 und Deckplatten 74, 76, die sämtlich transparent sind. Dabei trägt die untere Deckplatte 74 eine Spiegelschicht 78, so daß das gesamte von den Leuchtmitteln 56 erzeugte Licht nach einer Seite hin abgegeben wird.

Der zwischen den einzelnen Leuchtmitteln 56 und dem Paneelgehäuse 70 liegende Raum ist wieder mit Silikonöl 80 gefüllt, um die Wärmeabführung zur Umgebung zu begünstigen. In diesem sind wieder Phosphorpartikel 60 verteilt, wie oben beschrieben.

Ein mattierte untere Begrenzungsfläche 82 der Deckplatte 76 sorgt für eine gleichförmige Leuchtdichte des Leuchtpaneeles.

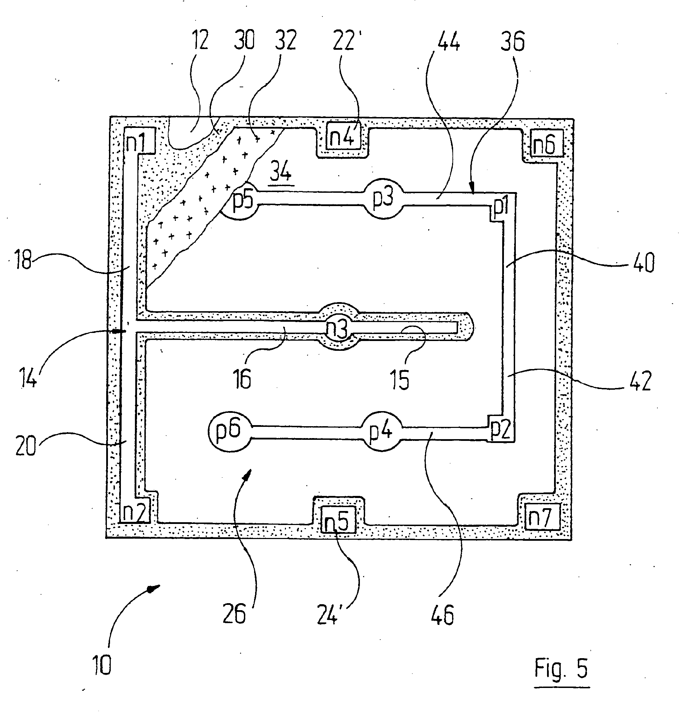

Das Ausführungsbeispiel nach Figur 5 ähnelt demjenigen nach Figur 1. Die Kontaktarme 22, 24 und 44, 46 sind nun aber nicht direkt mit Strom zuführenden Leiterbahnen verbunden, wie sie in Figur 1 bei 16 und 38 gezeigt sind, vielmehr sind auf ihre Länge verteilt sieben Anschlußpolster n1 bis n7 vorgesehen. Entsprechend tragen die Kontaktarme 44, 46 Anschlußpolster p1 bis p6.

Auf die Anschlußpolster ni (i=1 bis 7) und/oder pi (i=1 bis 6) ist jeweils ein kleines Volumen Lot aufgebracht (nicht dargestellt), welches bei etwa 350° C schmilzt.

Die Kontaktarme stehen in Verbindung mit der Unterseite bzw. Oberseite eines einzigen flächigen Leuchtelements 26, das wieder aus den drei Schichten 30, 32 und 34 besteht.

Um die Schicht 30 von derselben Seite her kontaktieren zu können wie die Schicht 34 und auch zum mitteleren Bereich der Schicht 30 Zugang zu haben, weist die Schicht 34 eine mittlere schlitzförmige Ausnehmung 15 auf, in welcher der Leiterbahnabschnitt 16 unter seitlichem Abstand Aufnahme findet.

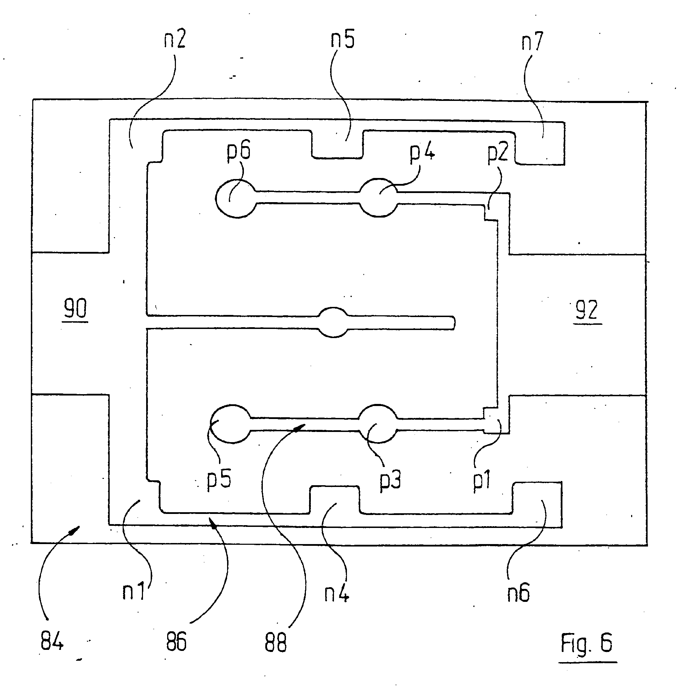

Figur 6 zeigt eine Aufsicht auf eine untere Basisplatte 84, auf welche die Leuchelement-Einheit 10 von Figur 5 so auflötbar ist, daß die in figur 5 obere Seite nach unten weist und die Oberseite der Basisplatte 84 kontaktiert.

Die Basisplatte 84 hat eine positive Speiseleiterbahn 86 und eine negative Speiseleiterbahn 88. Diese haben im wesentlchen die gleiche Geometrie wie die Elektroden 14 und 36 und sind ebenfalls mit Anschlußpolstern n1 bis n7 und p1 bis p6 versehen, derart, daß beim Auflöten der in Figur 5 gezeigten Leuchtmitteleinheit auf die Basisplatte 84 die Elektroden 16, 36 an mehreren beabstandeten Stellen mit den Speiseleiterbahnen 86, 88 verbunden werden.

Die Speiseleiterbahnen 86, 88 können wesentlich dicker auf die Basisplatte 84 aufgebracht sein (in der Praxis 4 bis 10 mal so dick) und damit einen wesentlich niedereren Widerstand haben als die sehr dünnen Elektroden 14, 36, deren Dicke in der Praxis 10µm bis 40 µm beträgt.

Die Elektroden 14, 36 und die Speiseleiterbahnen 86, 88 sind durch Aufdampfen eine Kupfer-Gold-Legierung erhalten. Alternativ können auch Silber- oder AluminiumLegierungen verwendet werden.

Die Speiseleiterbahnen 86, 88 sind mit großen Kontakten 90, 92 verbunden, über welche der Anschluß an die Spannungsqelle erfolgt.

Bei einem praktischen Ausführungsbeispiel des in den Figuren 5 und 6 gezeigten Leuchtmittels besteht die Schicht 30 der Leuchtelemente 26 aus InGaN und die Schicht 34 aus GaN. Die Mittelschicht 32 ist wieder eine MQW-Schicht (multiple quantum well-Schicht), die ein Übergitter bildet, über welches man die Wellenlänge des emittierten Lichtes beeinflussen kann.

Die Substratplatte 12 hat bei dem praktischen Ausführungsbeispiel eine Kantenabmessung von etwa 1 mm bei einer Dicke von etwa 0,15 mm. Die Basisplatte 84 hat Kantenlängen von etwa 1,9 mm und 1,5 mm und eine Plattendicke von etwa 0,4 mm. Beide Platten sind aus Saphir geschnitten.

Die Anschlußpolster sind in üblicher Weise aus Gold hergestellt, welches für den Anschluß an eine p-leitende Schicht bzw. eine n-leitende Schicht dotiert ist.

Die obenstehend unter Bezugnahme auf die Figuren 5 und 6 beschriebene Konstruktion erlaubt eine im wesentlichen durchgehend transparente Lichtquelle mit gleichförmiger Leuchtdichte.

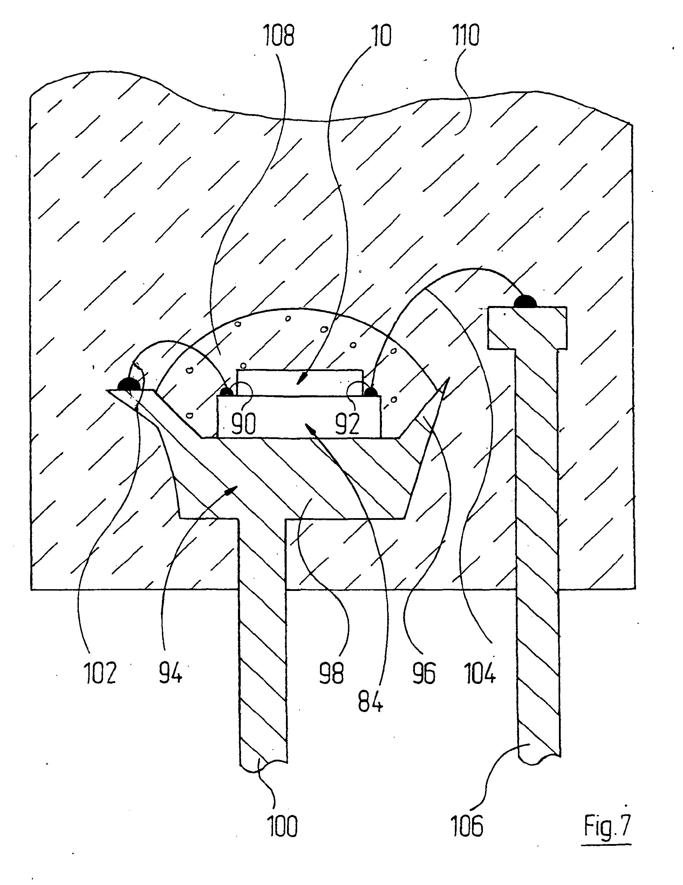

Gemäß Figur 7 ist die Leuchtelementeeinheit 10, von welcher die Substratplatte 12 und die Basisplatte 84 nur schematisch angedeutet sind, im Inneren eines schüsselförmigen Reflektors 94 angeordnet. Dieser hat eine nach oben spitz zulaufende kegelige Umfangswand 96, eine Bodenwand 98 und einen Kontaktstift 100.

Über einen Draht 102 ist die Leuchtelementeeinheit elektrisch mit dem Reflektor 94 verbunden.

Ein weiterer Draht 104 verbindet die zweite Anschlußklemme der Leuchtelementeeinheit mit einem weiteren Kontaktstift 106, der parallel unter Abstand zum Kontaktstift 100 angeordnet ist.

Die Leuchtelementeeinheit 10 ist mit einem Konversionsmaterial 108 überschichtet, welches ein Silikon/Phosphor-Gemisch ist. Dabei ist das Phosphor-Material wieder eine Mischung unterschiedlicher Phosphor-Materialien, die das von der Leuchtelementeeinheit 10 emittierte Licht absorbieren und im Blauen, Gelben und Roten emittieren, wie weiter oben beschrieben.

Die gesamte oben beschriebene Einheit ist in ein Volumen aus transparentem Epoxidharz 110 eingebettet, welches eine zylindrische Grundgeometrie bei ggfs. kalottenförmiger Endfläche aufweist, wie an sich von Leuchtelemente her bekannt.

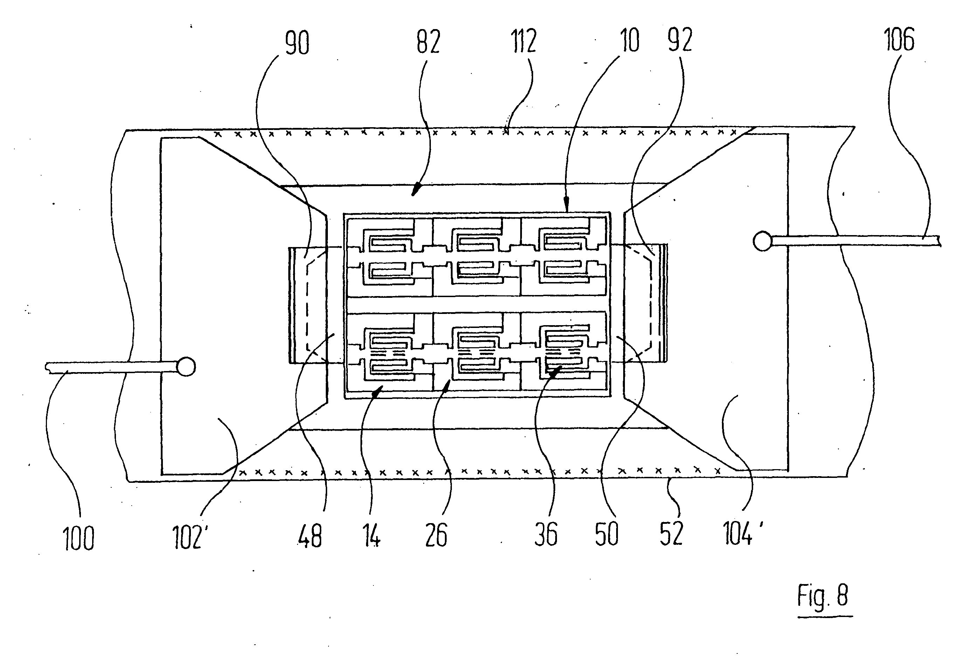

Figur 8 zeigt ein Leuchtmittel, welches ähnlich ist zu demjenigen nach Figur 2. Vergleichbare Teile sind wieder mit demselben Bezugszeichen versehen.

Ein Unterschied zum Leuchtmittel nach Figur 2 besteht darin, daß bei dem Leuchtmittel nach Figur 8 zwei Leuchtelement-Einheiten 10 Rücken an Rücken in das Gehäuse 52 eingebaut sind.

Außerdem ist vorgesehen, daß die Innenfläche des Gehäuses 52 zusätzlich eine Phosphorschicht 112 trägt, die wieder ein Gemisch aus Phosphorpartikeln darstellt, die das von den Leuchtelemente abgegebene Licht absorbieren und im Blauen, Gelben und Roten emittieren.

Großzüzgig bemessene Anschlußplatten 102' und 104' sind aus Metall hergestellt und dienen auch dazu, Wärme von den Leuchtelemente abzuführen.

Das Gehäuse 52 ist ein Glaszylinder 52, der unter einem Vakuum von etwa 2 x 10⁻2 bis 5 x 10⁻4 Torr steht.

Auf die Innenseite der Glaswand des Gehäuses 52 ist eine gitterförmige Elektrode 114 aus Graphit aufgebracht. Die Graphit-Elektrode 114 steht mit einem Anschluß 116 in Verbindung, der von einer Hochspannungsquelle 118 her mit Spannung beaufschlagt werden kann. Diese kann im Bereich von 220 V bis 10 kV liegen.

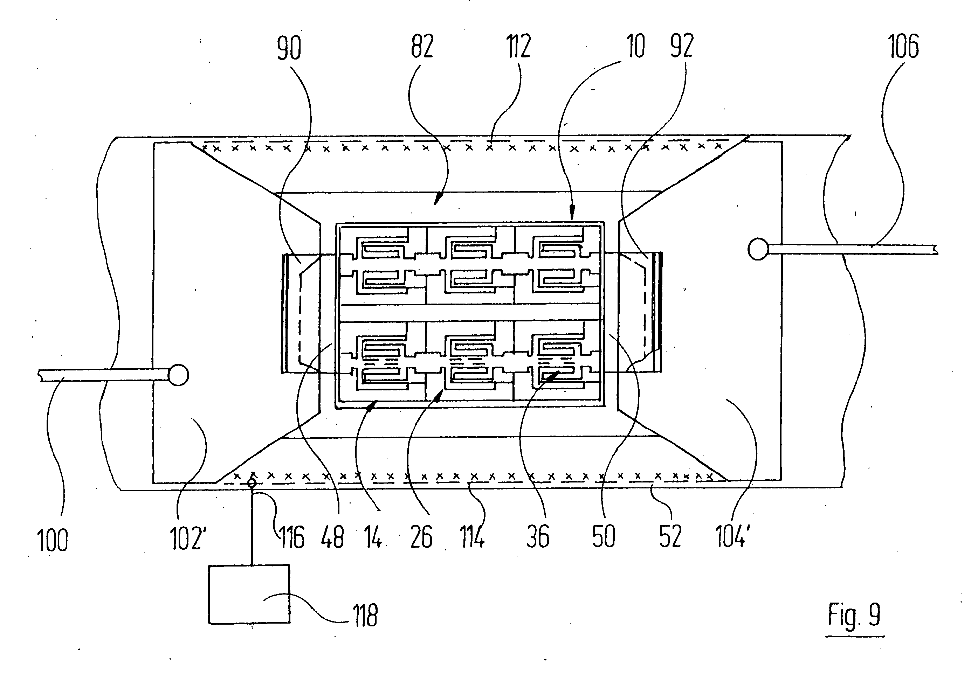

Das in Figur 9 gezeugte Leuchtmittel kann wahlweise mit Niederspannung betrieben werden (Anlegen einer Spannung von etwa 7,5 bis etwa 11 V an die Anschlußplatten 48, 50) oder mit Hochspannung betrieben werden (Anlegen von Hochspannung an den Anschluß 116 und Anschluß von Masse an die Anschlußplatte 50).

Zur Herstellung von Weißlicht kann die Elektrode 114 tragende Innenfläche des Gehäuses 52 wieder mit einer Phosphorschicht 112 belegt sein, wie weiter oben beschrieben. Dabei kann die Phosphorschicht 112 zugleich die Gittermaschen der Elektrode 114 ausfüllen.

Bei den unter Bezugnahme auf die Figuren 5 bis 9 erläuterten Ausführungsbeispielen erfolgt das Herstellen des Leuchtmittels in drei Teilschritten: Das Herstellen der Leuchtelement-Einheit 10 auf dem Saphir-Substrat 12, das Herstellen der Saphir-Basisplatte 84 und der von dieser getragenen Speiseleiterbahnen 86, 88 und das Verbinden von Leuchtelement-Einheit 10 und Basisplatte 84.

Auf die Anschlußpolster n1 bis n7 und p1 bis p6 von Substratplatte 12 und/oder Basisplatte 84 wurden bei deren Herstellung kleine Lötmaterialtröpfchen aufgebracht, die dann gemeinsam in einem heißen Verfahren bei etwa 350°C unter Einwirkung von Druck aufgeschmolzen werden. Nach dem Erkalten des Lotes sind Leuchtelementeeinheit 10 und Basisplatte 84 zugleich mechanisch und elektrisch verbunden.

Die gesamten Herstellungschritte für die Leuchtmittel lassen sich somit einfach unter Verwendung der bekannten Halbleiter-Herstellungsverfahren durchführen.

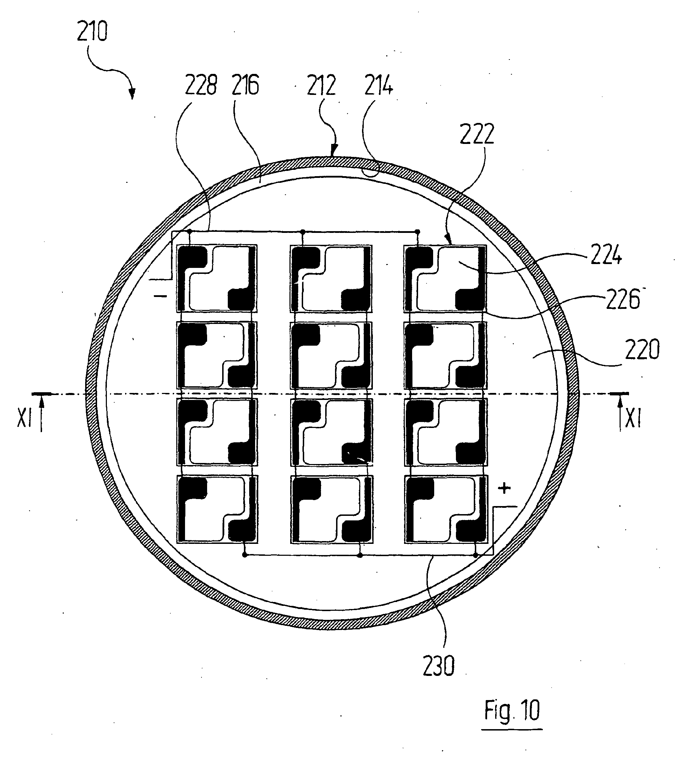

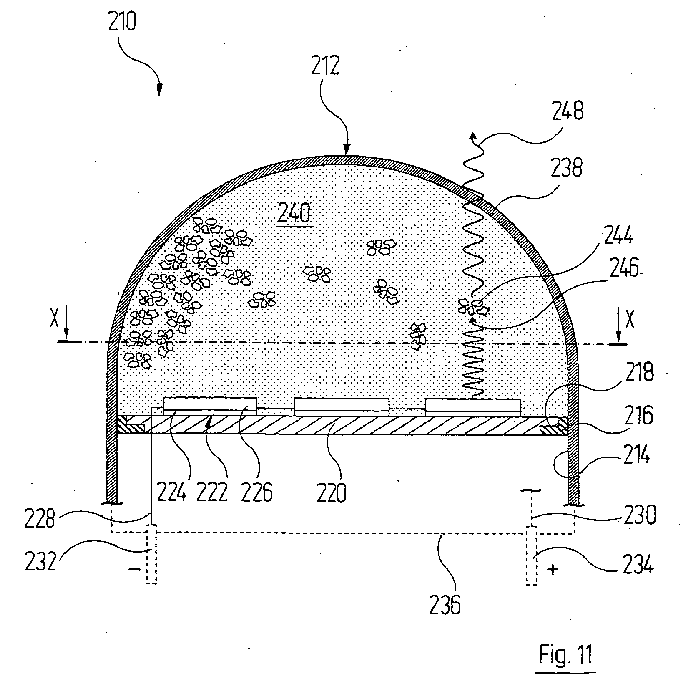

Die Figuren 10 und 11 zeigen Schnitte eines weiteren Leuchtelements 210. Dieses umfaßt ein zylindrisches Gehäuse 212 aus transparentem Glas oder Kunststoff.

An die zylindrische Innenwand 214 des Gehäuses 212 ist ein Haltering 216 angeflanscht, welcher eine radial innenliegende umlaufende Stufe 218 aufweist. In dieser liegt eine an dem Haltering 216 befesigte Trägerplatte 220.

Die Trägerplatte 220 ist ein Verbundsystem, welches an seiner Oberfläche Schichtabschnitte aus Chrom, Platin und Gold hat, und weist gute reflektierende Eigenschaften auf.

Auf der Trägerplatte 220 sitzen 12 in einer 3x4-Matrix angeordnete Leuchtchip-Kristalle 222, von denen exemplarisch einer mit Bezugszeichen versehen ist. Die Leuchtchip-Kristalle 222 sind als InGaN/GaN-Struktur 224 auf einem Saphirträger 226 ausgestaltet und sitzen mit dem Saphirträger 226 auf der Trägerplatte 220.

Wie in Figur 10 zu erkennen ist, sind in der 3x4-Matrix der Leuchtchip-Kristalle 222 drei in Reihe geschaltete Ketten à 4 Leuchtchip-Kristallen 222 parallel geschaltet. Die Leuchtchip-Kristalle 222 werden über eine Kathodenleitung 228 (-) und eine Anodenleitung 230 (+) mit Energie versorgt.

Die Leitungen 228, 230 sind in herkömmlicher Weise mit Anschlußstiften 232 bzw. 234 (Figur 2) verbunden, welche aus einem Befestigungssockel 236 des Leuchtelementes 210 herausragen.

Bei dem Befestigungssockel 236 und den Anschlußstiften 232, 234 handelt es sich um herkömmliche Bauteile, welche in Figur 11 der Übersichtlichkeit halber lediglich schematisch durch gestrichelte Linien dargestellt sind.

Wird das Leuchtelement über die Anschlußstifte 232, 234 mit Spannung versorgt, beginnen die Leuchtchip-Kristalle 222 zu leuchten. Die emittierte Wellenlänge ist dabei bauartbedingt (Natur des Halbleitermateriales). Auf Grund der vorliegend eingesetzten InGaN/ GaN-Strukturen 224 emittieren die Leuchtchip-Kristalle 222 blaues Licht bei einer Wellenlänge von etwa 470 nm.

Wie in Figur 11 zu erkennen ist, ist das Gehäuse 12 auf der dem Anschlußsockel 236 gegenüberliegenden Seite durch einen halbkugelförmigen Gehäuseendabschnit 238 abgeschlossen, durch welchen die erzeugte Strahlung aus dem Leuchtelement 210 austritt.

Der Gehäuseendabschnitt 238 begrenzt zusammen mit der Trägerplatte 220 und dem Haltering 216 eine Kammer 240. Die Leuchtchip-Kristalle 222 strahlen in die Kammer 240 ab, im wesentlichen parallel zur Längsachse des Gehäuses 212.

Die Kammer 240 ist mit einer Flüssigkeit in Form von Silikonöl 242 gefüllt, in welchem ein fein gemahlenes kristallines oder amorphes Fluoreszenzmaterial 244 homogen dispergiert ist. Dies ist in Figur 11 schematisch angedeutet. Das Silikonöl 242 dient so einerseits als Trägermittel für das Fluoreszenzmaterial 244, die wiederum ein Emissionsmedium zur Veränderung einer Wellenlänge darstellen, andererseits als Kühlflüssigkeit.

Das Fluoreszenzmaterial 244 umfaßt, wie weiter oben schon dargelegt, bei Bestrahlung mit blauem Licht im Grünen emittierende Fluoreszenzpartikel sowie bei Bestrahlung mit blauem Licht im Roten emittierende Fluoreszenzpartikel. Dies ist in Figur 11 durch die Wellenpfeile 246 bzw. 248 dargestellt. Dabei repräsentiert der Pfeil 246 das von den Oberflächen 250 der Leuchtchip-Kristalle 222 emittierte kurzwellige blaue Licht bei etwa 470 nm, wogegen der Wellenpfeil 248 das von einem Fluoreszenzpartikel 244 emittierte grüne bzw. rote Licht repräsentiert, welches eine Wellenlänge von etwa 580 nm bzw. etwa 630 nm aufweist.

Die Konzentration bzw. die Verteilung des Fluoreszenzmaterials 244 in dem Silikonöl 242 ist derart gewählt, daß lediglich ein Teil des blauen Lichts der Leuchtchip-Kristalle 222 von dem Fluoreszenzmaterial 244 absorbiert wird, so daß dieses auch nur teilweise in grünes oder rotes Licht umgewandelt wird. Die Mischung des somit die Leuchtelement 210 verlassenden blauen, grünen und roten Lichts ergibt weißes Licht.

Ergibt sich in der Praxis, daß bei einem Fluoreszenzmaterial das bei Bestrahlung mit blauem Licht erhaltene Weißlicht einen zu geringen Blauanteil aufweist, so kann man entweder die Konzentration des Fluoreszenzmaterials im Silikonöl herabsetzen oder dem Fluoreszenzmaterial zusätzlich noch transparente Glas- oder Kunststoffpartikel zusetzen, welche das blaue Licht nicht absorbieren.

Das Silikonöl 242 hat zusätzlich durch seine gute Wärmeleitfähigkeit einen wärmeableitenden Effekt. Die Arbeitswärme der Leuchtchip-Kristalle 222 wird durch das Silikonöl 242 zur Gehäusewand des Gehäuses 212 und über diese an die Umgebung abgeführt.

Anstelle der InGaN/GaN-Struktur 224 können auch andere Strukturen eingesetzt werden, welche Primärstrahlung anderer ebenfalls kurzer Wellenlängen emittieren. Verwendet man dabei Strukturen, die bei sehr kurzen Wellenlängen (violett oder ultra-violett) emittieren, so muß man unter Umständen dem Fluoreszenzmaterial noch eine andere Leuchtstoffart zusetzen, welche das sehr kurzwellige Primärlicht absorbiert und im Blauen fluoresziert. Es versteht sich, dass man in diesem Falle dann die Leuchtstoffe für Rot und Grün so auslegen kann, dass sie direkt das violette oder das ultra-violette Licht absorbieren. Alternativ wäre denkbar, daß diese Leuchtstoffe weiterhin im blauen absorbieren, als nur indirekt erregt werden.

Durch entsprechende Auswahl des Fluoreszenzmateriales 244 bei derartigen Leuchtelementen kann das Spektrum der letztendlich von dem Leuchtelement abgegebenen Strahlung an den jeweiligen Bedarf angepasst werden.

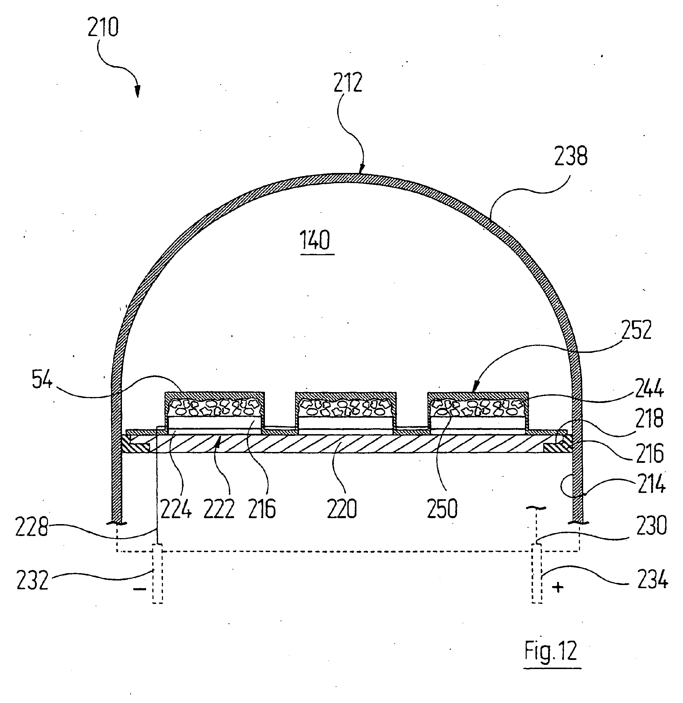

Figur 12 zeigt ein weiteres Ausführungsbeispiel eines Leuchtelementes 210, wobei den Figuren 10 und 11 entsprechende Komponenten mit denselben Bezugszeichen gekennzeichnet sind.

Wie in Figur 12 zu erkennen, ist die Kammer 240 nicht mit Silikonöl und dispergiertem Fluoreszenzmaterial gefüllt. Das Fluoreszenzmaterial 244, ist vielmehr direkt homogen auf die Primärstrahlung emittierende Oberfläche 250 der Leuchtchip-Kristalle 222 aufgetragen. Dazu kann man sich eines an sich bekannten Beschichtungsverfahrens bedienen.

Es bietet sich an, hierzu fein gemahlenes Fluoreszenzmaterial 244 zu verwenden, welches als Pulver aufgetragen werden kann und so eine Oberflächenschicht 252 bildet.

Diese ist mittels einer Abdeckfolie 254 als Fixiermittel auf der Strahlung emittierenden Oberfläche 250 der Leuchtchip-Kristalle 222 gehalten. Dazu ist die Abdeckfolie 254 auf die Trägerplatte 220 mit den Leuchtchip-Kristallen 222 aufgeschrumpft.

Die Abdeckfolie 254 kann auch auf andere Art fixiert sein, beispielsweise durch Verkleben.

Die Abdeckfolie 254 ist sowohl für diejenige Strahlung durchlässig, welche von den Leuchtchip-Kristallen 222 emittiert wird, als auch für diejenige Strahlung, welche von dem Fluoreszenzmaterial 244 emittiert wird.

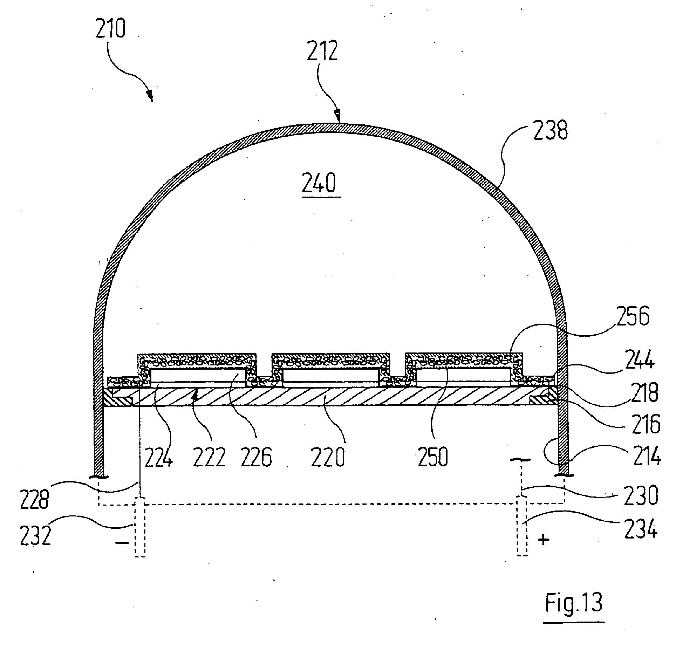

Ein weiteres Ausführungsbeispiel ist in Figur 13 gezeigt, wobei den Figuren 10 und 11 entsprechende Komponenten mit denselben Bezugszeichen gekennzeichnet sind.

Bei dem Leuchtelement 210 ist auf den Leuchtchip-Kristallen 222 und der Trägerplatte 220 eine Verbundfolie 256 als Trägermittel für das Fluoreszenzmaterial 244 vorgesehen, in welche der Fluoreszenzmaterial 244 als Komponente eingearbeitet ist. Die Verbundfolie 256 ist wie die Abdeckfolie 254 auf den Leuchtchip-Kristall 226 aufgeschrumpft oder aufgeklebt.

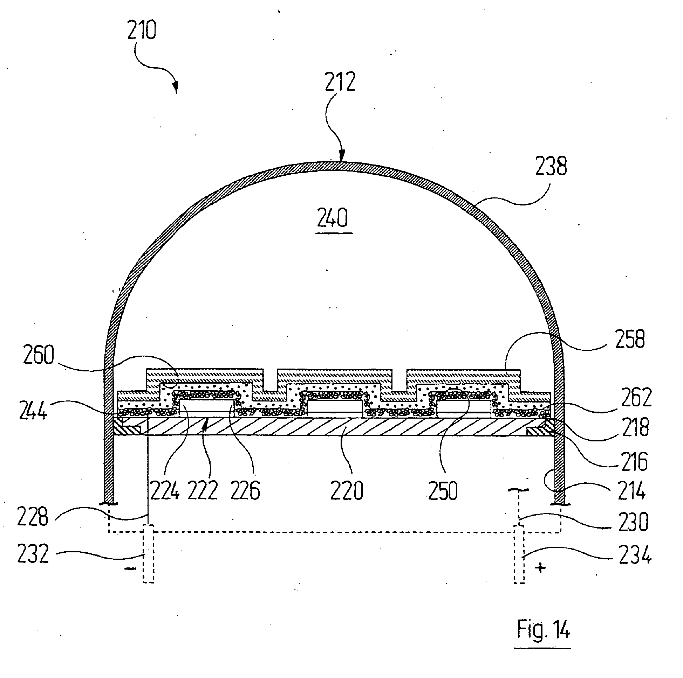

Bei dem in Figur 14 gezeigten weiteren Ausführungsbeispiel einer Leuchtdiode 210 sind den Figuren 10 und 11 entsprechende Komponenten mit denselben Bezugszeichen gekennzeichnet.

Dort ist als Fixiermittel eine Fixierfolie 258 vorgesehen. Diese weist auf ihrer den Leuchtchip-Kristallen 222 zugewandten Seite 260 eine Klebstoff-Schicht 262 auf. Auf diese ist das Fluoreszenzmaterial 244 in homogener Verteilung aufgetragen und somit mit der Fixierfolie 258 verbunden.

Das Schichtsystem aus Fixierfolie 258, Klebstoff-Schicht 262 und Fluoreszenzmaterial 244 ist auf die Leuchtchip-Kristalle 222 und die Trägerplatte 220 aufgeschrumpft oder aufgeklebt, derart, daß das Fluoreszenzmateriäl 244 in Richtung auf die Leuchtchip-Kristalle 222 weist.

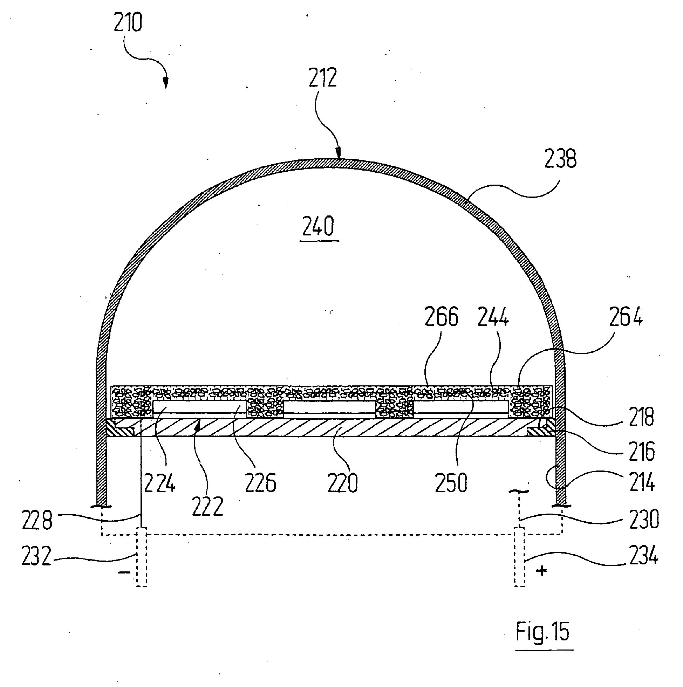

Bei dem in Figur 15 gezeigten Ausführungsbeispiel der Leuchtdiode 210 sind den Figuren 10 und 11 entsprechende Komponenten mit denselben Bezugszeichen gekennzeichnet.

Bei der Leuchtdiode 210 ist als den Fluoreszenzmaterial 244 tragendes Mittel ein Lack 264 vorgesehen, der ein Bindemittel 266 umfaßt. Das Bindemittel 266 gewährleistet, daß das Fluoreszenzmaterial 244 homogen in dem Lack 264 verteilt ist.

Die Kammern 240 der Leuchtdioden 210 der Ausführungsbeispiele nach den Figuren 12 bis 15 können entweder mit einem Inertgas gefüllt sein oder zur Unterstützung des gewünschten Effektes zusätzlich wie bei dem Ausführungsbeispiel nach den Figuren 10 und 11 mit Silikonöl gefüllt sein, in welchem das Fluoreszenzmaterial dispergiert ist.

## Patentansprüche

1. Halbleiter-Leuchtmittel mit bei Spannungsbeaufschlagung leuchtenden Halbleiter-Leuchtelementen (26, 28; 222) und einem diese tragenden Substrat (12; 220), wobei
a) das Substrat (12; 220)
oder
b) das Substrat (12; 220) und eine die Halbleiter-Leuchtelemente (26, 28; 222) umgebende Flüssigkeit (54; 240)
für das von den Halbleiter-Leuchtelementen (26, 28; 222) erzeugte Licht durchlässig ist,
**dadurch gekennzeichnet, dass**
das Substrat (12; 220) auf beiden Seiten Halbleiter-Leuchtelemente (26, 28; 222) trägt und dass die auf den beiden Seiten des Substrates (12; 220) angeordneten Sätze von Halbleiter-Leuchtelementen (26, 28; 222) gegeneinander versetzt sind.

2. Leuchtmittel nach Anspruch 1, **dadurch gekennzeichnet, dass** das substrat (12; 220) ein Glasmaterial oder ein Kristallmaterial umfasst.

3. Leuchtmittel nach Anspruch 2, **dadurch gekennzeichnet, dass** das Glasmaterial oder das Kristallmaterial ein Al₂O₃-Material ist, insbesondere eine Saphirmaterial.

4. Leuchtmittel nach einem der Ansprüche 1 bis 3, **dadurch gekennzeichnet, dass** das Substrat (12; 220) eine Dicke von etwa 0,1 mm bis etwa 1 mm, vorzugsweise von etwa 0,1 mm bis etwa 0,5 mm, nochmals vorzugsweise von etwa 0,2 mm bis etwa 0,4 mm aufweist.

5. Leuchtmittel nach einem der Ansprüche 1 bis 4, **dadurch gekennzeichnet, dass** mindestens ein Halbleiter-Leuchtelement (26, 28; 222) eine Dreischichtstruktur ist, wobei die erste Schicht (30) eine Halbleiterschicht, die zweite Schicht (32) eine MQW-Schicht und die dritte Schicht (34) eine Halbleiterschicht ist.

6. Leuchtmittel nach einem der Ansprüche 1 bis 5, **dadurch gekennzeichnet, dass** die Halbleiter-Leuchtelemente (26, 28; 222) transparent sind.

7. Leuchtmittel nach einem der Ansprüche 1 bis 6, **dadurch gekennzeichnet, dass** eine Mehrzahl von Halbleiter-Leuchtelementen (26, 28; 222) durch verschachtelte Elektroden (14, 36) kontaktiert sind.

8. Leuchtmittel nach einem der Ansprüche 1 bis 7, **gekennzeichnet durch** ein für das von den Halbleiter-Leuchtelementen (26, 28; 222) erzeugte Licht durchlässiges Gehäuse (56), von welchem das Substrat (12; 220) getragen ist.

9. Leuchtmittel nach Anspruch 8, **dadurch gekennzeichnet, dass** das Gehäuse (56) eine Mehrzahl von Substraten (12; 220) umschließt.

10. Leuchtmittel nach Anspruch 8 oder 9, **dadurch gekennzeichnet, dass** das Innere des Gehäuses (56; 212) eine transparente Flüssigkeit (54; 242) enthält.

11. Leuchtmittel nach Anspruch 10, **dadurch gekennzeichnet, dass** die transparente Flüssigkeit ein Silikonöl ist.

12. Leuchtmittel nach einem der Ansprüche 8 bis 11, **dadurch gekennzeichnet, dass** die Halbleiter-Leuchtelemente (26, 28; 222) im UV oder im Blauen strahlen und im Inneren des Gehäuses Phosphorpartikel verteilt sind, die im Blauen, Gelben und Roten emittieren, derart, dass das Leuchtmittel weißes Licht abgibt.

13. Leuchtmittel nach Anspruch 12, **dadurch gekennzeichnet, dass** die Phosphorpartikel auf das Substrat (12; 220) und/oder die Halbleiter-Leuchtelemente (26, 28; 222) und/oder die Innen- oder Außenfläche des Gehäuses (56; 212) aufgebracht sind.

14. Leuchtmittel nach Anspruch 12 oder 13, **dadurch gekennzeichnet, dass** die Phosphorpartikel in einer Flüssigkeit (54; 242) oder einem festen transparenten Einbettungsmaterial verteilt sind, die/das das die Halbleiter-Leuchtelemente (26, 28; 222) tragende Substrat (12; 220) umgibt.

15. Leuchtmittel nach einem der Ansprüche 1 bis 14, **dadurch gekennzeichnet, dass** hinter dem HalbleiterElement (26, 28; 222) ein Reflektorteil (98) angeordnet ist.

16. Leuchtmittel nach Anspruch 15, **dadurch gekennzeichnet, dass** das Reflektorteil (98) aus einem Kristallmaterial hergestellt ist, welches vorzugsweise auf der Rückseite verspiegelt ist.

17. Leuchtmittel nach einem der Ansprüche 9 bis 16, **dadurch gekennzeichnet, dass** die Innenseite des Gehäuses (56; 212) eine lichtdurchlässige Elektrode (114) trägt

18. Leuchtmittel nach Anspruch 17, **dadurch gekennzeichnet, dass** die Elektrode (114) als Gitter ausgebildet ist.

19. Leuchtmittel nach Anspruch 18, **dadurch gekennzeichnet, dass** die Elektrode (114) aus Graphit hergestellt ist.

20. Leuchtmittel nach einem der Ansprüche 17 bis 19, **dadurch gekennzeichnet, dass** die Elektrode (114) mit Phosphormaterial (112; 220) überschichtet ist.

21. Leuchtmittel nach einem der Ansprüche 17 bis 20, **dadurch gekennzeichnet, dass** die Elektrode (114) mit einer Anschlussklemme (116) in Verbindung steht, die mit einer Hochspannungsquelle (118) verbindbar ist.

22. Leuchtmittel nach einem der Ansprüche 13 bis 21, **dadurch gekennzeichnet, dass** eine Fixierfolie (254; 258) vorgesehen ist, mittels der die Phosphorpartikel (244) auf dem Halbleiter-Leuchtelement (222) oder der Innen- oder Außenfläche des Gehäuses (56; 212) fixiert sind.

23. Leuchtmittel nach Anspruch 22 **dadurch gekennzeichnet, dass** die Fixierfolie (258) auf einer Seite (260) eine Klebstoffschicht (262) aufweist, auf welche das Emissionsmedium (244) aufgetragen ist, wobei die Fixierfolie (258) derart auf den Halbleiter-Leuchtelement (222) aufgebracht ist, dass das Phosphorpartikel (244) zwischen der Primärlicht emittierenden Oberfläche (250) des Halbleiter-Leuchtelements (222) und der Fixierfolie (258) angeordnet ist.

24. Leuchtmittel nach Anspruch 22 oder 23, **dadurch gekennzeichnet, dass** die Fixierfolie (254; 256; 258) transparenten Kunststoff umfasst.

25. Leuchtmittel nach einem der Ansprüche 13 bis 21, **dadurch gekennzeichnet, dass** ein Lack (264) vorgesehen ist, welcher auf wenigstens einen Teil der Primärlicht emittierenden Oberfläche (250) des Halbleiter-Leuchtelementes (222) aufgetragen ist und Phosphorpartikel (244) enthält.

26. Leuchtpaneel, **gekennzeichnet durch** eine Vielzahl von Leuchmitteln nach einem der Ansprüche 1 bis 25, welche in einem planparallele Deckplatten (74, 76) aufweisenden Paneelgehäuse (70) angeordnet sind, wobei der zwischen den Leuchtmitteln (56; 212) und dem Paneelgehäuse liegende Raum **durch** eine transparente Kühlflüssigkeit, insbesondere ein Silikonöl gefüllt ist.

27. Leuchtpaneel nach Anspruch 26, **dadurch** ge**gekennzeichnet**, **dass** eine (74) der Deckplatten (74, 76) verspiegelt (78) ist.

28. Leuchtpaneel nach der Ansprüche 26 oder 27, **dadurch gegekennzeichnet, dass** eine (74) der Deckplatten (74, 76) als Mattscheibe (82) ausgebildet ist.

## Claims

1. Semiconductor light-emitting means having semiconductor light-emitting elements (26, 28; 222) which luminesce when a voltage is applied, and a substrate (12; 226) carrying the latter, wherein
a) the substrate (12; 220)
or
b) the substrate (12; 220) and a liquid (54; 240) surrounding the semiconductor light-emitting elements (26, 28; 222)
is transparent for the light generated by the semiconductor light-emitting elements (26, 28; 222),
**characterised in that**
the substrate (12; 220) carries semiconductor light-emitting elements (26, 28; 222) on both sides, and **in that** the sets of semiconductor light-emitting elements (26, 28; 222) being arranged on both sides of the substrate (12; 220) are mutually offset.

2. Light-emitting means according to Claim 1, **characterised in that** the substrate (12; 220) comprises a glass material or a crystal material.

3. Light-emitting means according to Claim 2, **characterised in that** the glass material or the crystal material is an Al₂O₃ material, in particular a sapphire material.

4. Light-emitting means according to one of Claims 1 to 3, **characterised in that** the substrate (12; 220) has a thickness of from about 0.1 mm to about 1 mm, preferably from about 0.1 mm to about 0.5 mm, more preferably from about 0.2 mm to about 0.4 mm.

5. Light-emitting means according to one of Claims 1 to 4, **characterised in that** at least one semiconductor light-emitting element (26, 28; 222) is a triple layer structure, the first layer (30) being a semiconductor layer, the second layer (32) an MQW layer and the third layer (34) a semiconductor layer.

6. Light-emitting means according to one of Claims 1 to 5, **characterised in that** the semiconductor light-emitting elements (26, 28; 222) are transparent.

7. Light-emitting means according to one of Claims 1 to 6, **characterised in that** a multiplicity of semiconductor light-emitting elements (26, 28; 222) are contacted by interdigitated electrodes (14, 36).

8. Light-emitting means according to one of Claims 1 to 7, **characterised by** a package (56), transparent for the light generated by the semiconductor light-emitting elements (26, 28; 222), by which the substrate (12; 220) is carried.

9. Light-emitting means according to Claim 8, **characterised in that** the package (56) encloses a multiplicity of substrates (12; 220).

10. Light-emitting means according to Claim 8 or 9, **characterised in that** the interior of the package (56; 212) contains a transparent liquid (54; 242).

11. Light-emitting means according to Claim 10, **characterised in that** the transparent liquid is a silicone oil.

12. Light-emitting means according to one of Claims 8 to 11, **characterised in that** the semiconductor light-emitting elements (26, 28; 222) radiate in UV or blue and phosphor particles, which emit in blue, yellow and red, are distributed in the interior of the package so that the light-emitting means delivers white light.

13. Light-emitting means according to Claim 12, **characterised in that** the phosphor particles are applied onto the substrate (12; 220) and/or the semiconductor light-emitting elements (26, 28; 222) and/or the inner or outer surface of the package (56; 212).

14. Light-emitting means according to Claim 12 or 13, **characterised in that** the phosphor particles are distributed in a liquid (54; 242) or a solid transparent embedding material, which surrounds the substrate (12; 220) carrying the semiconductor light-emitting elements (26, 28; 222).

15. Light-emitting means according to one of Claims 1 to 14, **characterised in that** a reflector part (98) is arranged behind the semiconductor light-emitting element (26, 28; 222).

16. Light-emitting means according to Claim 15, **characterised in that** the reflector part (98) is made from a crystal material, which is preferably mirrored on the rear side.

17. Light-emitting means according to one of Claims 9 to 16, **characterised in that** the inner side of the package (56; 212) carries a transparent electrode (114).

18. Light-emitting means according to Claim 17, **characterised in that** the electrode (114) is designed as a grid.

19. Light-emitting means according to Claim 18, **characterised in that** the electrode (114) is made from graphite.

20. Light-emitting means according to one of Claims 17 to 19, **characterised in that** the electrode (114) is overlaid with phosphor material (112; 220).

21. Light-emitting means according to one of Claims 17 to 20, **characterised in that** the electrode (114) is in communication with a connection terminal (116), which can be connected to a high-voltage source (118).

22. Light-emitting means according to one of Claims 13 to 21, **characterised in that** a fixing film (254; 258) is provided, by means of which the phosphor particles (244) are fixed on the semiconductor light-emitting element (222) or the inner or outer surface of the package (56; 212).

23. Light-emitting means according to Claim 22, **characterised in that** the fixing film (258) has on one side (260) an adhesive layer (262), onto which the emission medium (244) is applied, the fixing film (258) being applied onto the semiconductor light-emitting element (222) so that the phosphor particle (244) is arranged between the primary-light emitting surface (250) of the semiconductor light-emitting element (222) and the fixing film (258).

24. Light-emitting means according to Claim 22 or 23, **characterised in that** the fixing film (254; 256; 258) comprises transparent plastic.

25. Light-emitting means according to one of Claims 13 to 21, **characterised in that** a lacquer (264) is provided, which is applied onto at least a part of the primary-light emitting surface (250) of the semiconductor light-emitting element (222) and contains phosphor particles (244).

26. Light-emitting panel, **characterised by** a multiplicity of light-emitting means according to one of Claims 1 to 25, which are arranged in a panel package (70) having plane-parallel cover plates (74, 76), the space lying between the light-emitting means (56; 212) and the panel package being filled with a transparent cooling liquid, in particular a silicone oil.

27. Light-emitting panel according to Claim 26, **characterised in that** one (74) of the cover plates (74, 76) is mirrored (78).

28. Light-emitting panel according to claims 26 or 27, **characterised in that** one (74) of the cover plates (74, 76) is designed as a matt pane (82).

## Revendications

1. Source lumineuse semi-conductrice comprenant des éléments lumineux semi-conducteurs (26, 28 ; 222) qui sont luminescents quand ils sont soumis à une tension et un substrat (12 ; 220) qui les porte, dans laquelle
a) le substrat (12 ; 220)
ou
b) le substrat (12 ; 220) et un liquide (54 ; 240) entourant les éléments lumineux semi-conducteurs (26, 28 ; 222)
est ou sont transparent(s) à la lumière générée par les éléments lumineux semi-conducteurs (26, 28 ; 222),
**caractérisée en ce que**
le substrat (12 ; 220) porte des éléments lumineux semi-conducteurs (26, 28 ; 222) des deux côtés et que les jeux d'éléments lumineux semi-conducteurs (26, 28 ; 222) disposés des deux côtés du substrat (12 ; 220) sont décalés les uns par rapport aux autres.

2. Source lumineuse selon la revendication 1, **caractérisée en ce que** le substrat (12 ; 220) comprend un matériau de type verre ou un matériau de type cristal.

3. Source lumineuse selon la revendication 2, **caractérisée en ce que** le matériau de type verre ou le matériau de type cristal est un matériau en Al₂O₃, en particulier un matériau de type saphir.

4. Source lumineuse selon une des revendications 1 à 3, **caractérisée en ce que** le substrat (12 ; 220) présente une épaisseur d'environ 0,1 mm à environ 1 mm, de préférence d'environ 0,1 mm à environ 0,5 mm, encore plus de préférence d'environ 0,2 mm à environ 0,4 mm.

5. Source lumineuse selon une des revendications 1 à 4, **caractérisée en ce qu'**au moins un élément lumineux semi-conducteur (26, 28 ; 222) est une structure à trois couches, la première couche (30) étant une couche semi-conductrice, la deuxième couche (32) une couche MQW et la troisième couche (34) une couche semi-conductrice.

6. Source lumineuse selon une des revendications 1 à 5, **caractérisée en ce que** les éléments lumineux semi-conducteurs (26, 28 ; 222) sont transparents.

7. Source lumineuse selon une des revendications 1 à 6, **caractérisée en ce qu'**une pluralité d'éléments lumineux semi-conducteurs (26, 28 ; 222) sont contactés par des électrodes (14, 36) imbriquées.

8. Source lumineuse selon une des revendications 1 à 7, **caractérisée par** un boîtier (56) transparent à la lumière générée par les éléments lumineux semi-conducteurs (26, 28 ; 222), par lequel le substrat (12 ; 220) est porté.

9. Source lumineuse selon la revendication 8, **caractérisée en ce que** le boîtier (56) renferme une pluralité de substrats (12 ; 220).

10. Source lumineuse selon la revendication 8 ou 9, **caractérisée en ce que** l'intérieur du boîtier (56 ; 212) contient un liquide transparent (54 ; 242).

11. Source lumineuse selon la revendication 10, **caractérisée en ce que** le liquide transparent est une huile de silicone.

12. Source lumineuse selon une des revendications 8 à 11, **caractérisée en ce que** les éléments lumineux semi-conducteurs (26, 28 ; 222) rayonnent dans l'UV ou dans le bleu et qu'à l'intérieur du boîtier sont réparties des particules de phosphore qui émettent dans le bleu, le jaune et le rouge de sorte que la source lumineuse émet une lumière blanche.

13. Source lumineuse selon la revendication 12, **caractérisée en ce que** les particules de phosphore sont appliquées sur le substrat (12 ; 220) et/ou les éléments lumineux semi-conducteurs (26, 28 ; 222) et/ou la surface intérieure ou extérieure du boîtier (56 ; 212).

14. Source lumineuse selon la revendication 12 ou 13, **caractérisée en ce que** les particules de phosphore sont réparties dans un liquide (54 ; 242) ou un matériau d'enrobage solide transparent qui entoure le substrat (12 ; 220) qui porte les éléments lumineux semi-conducteurs (26, 28 ; 222).

15. Source lumineuse selon une des revendications 1 à 14, **caractérisée en ce qu'**une pièce réfléchissante (98) est disposée derrière l'élément semi-conducteur (26, 28 ; 222).

16. Source lumineuse selon la revendication 15, **caractérisée en ce que** la pièce réfléchissante (98) est réalisée dans un matériau de type cristal qui est de préférence métallisé sur la face arrière.

17. Source lumineuse selon une des revendications 9 à 16, **caractérisée en ce que** le côté intérieur du boîtier (56 ; 212) porte une électrode translucide (114).

18. Source lumineuse selon la revendication 17, **caractérisée en ce que** l'électrode (114) est réalisée sous la forme d'une grille.

19. Source lumineuse selon la revendication 18, **caractérisée en ce que** l'électrode (114) est réalisée en graphite.

20. Source lumineuse selon une des revendications 17 à 19, **caractérisée en ce que** l'électrode (114) est recouverte de matériau phosphore (112 ; 220).

21. Source lumineuse selon une des revendications 17 à 20, **caractérisée en ce que** l'électrode (114) est reliée à une borne de connexion (116) qui peut être reliée à une source de haute tension (118).

22. Source lumineuse selon une des revendications 13 à 21, **caractérisée en ce qu'**il est prévu une feuille de fixation (254 ; 258) au moyen de laquelle les particules de phosphore (244) sont fixées sur l'élément lumineux semi-conducteur (222) ou la surface intérieure ou extérieure du boîtier (56 ; 212).

23. Source lumineuse selon la revendication 22, **caractérisée en ce que** la feuille de fixation (258) présente d'un côté (260) une couche de colle (262) sur laquelle le milieu émissif (244) est appliqué, la feuille de fixation (258) étant appliquée sur l'élément lumineux semi-conducteur (222) de façon que la particule de phosphore (244) soit disposée entre la surface émettrice de lumière primaire (250) de l'élément lumineux semi-conducteur (222) et la feuille de fixation (258).

24. Source lumineuse selon la revendication 22 ou 23, **caractérisée en ce que** la feuille de fixation (254 ; 256 ; 258) comprend une matière plastique transparente.

25. Source lumineuse selon une des revendications 13 à 21, **caractérisée en ce qu'**il est prévu un vernis (264) qui est appliqué sur au moins une partie de la surface émettrice de lumière primaire (250) de l'élément lumineux semi-conducteur (222) et contient des particules de phosphore (244).

26. Panneau lumineux, **caractérisé par** une pluralité de sources lumineuses selon une des revendications 1 à 25, lequel est disposé dans un boîtier de panneau (70) présentant des plaques de recouvrement (74, 76) planes et parallèles, l'espace situé entre les sources lumineuses (56 ; 212) et le boîtier de panneau étant rempli d'un liquide de refroidissement transparent, en particulier d'une huile de silicone.

27. Panneau lumineux selon la revendication 26, **caractérisé en ce qu'**une (74) des plaques de recouvrement (74, 76) est métallisée.

28. Panneau lumineux selon la revendication 26 ou 27, **caractérisé en ce qu'**une (74) des plaques de recouvrement (74, 76) est réalisée sous la forme d'une vitre en verre dépoli (82).
